Europäisches Patentamt

European Patent Office

Office européen des brevets

(19)

(11) Veröffentlichungsnummer : **0 121 658
B1**

(12) # EUROPÄISCHE PATENTSCHRIFT

(45) Veröffentlichungstag der Patentschrift :
03.12.86

(21) Anmeldenummer : 84100697.6

(22) Anmeldetag : 24.01.84

(51) Int. Cl.⁴ : **G 01 D   5/36**

(54) **Messeinrichtung.**

(30) Priorität : **12.03.83 DE 3308813**

(43) Veröffentlichungstag der Anmeldung :
**17.10.84 Patentblatt 84/42**

(45) Bekanntmachung des Hinweises auf die Patenterteilung : **03.12.86 Patentblatt 86/49**

(84) Benannte Vertragsstaaten :
**AT CH DE FR GB IT LI NL SE**

(56) Entgegenhaltungen :
**CH-A-   374 207
CH-A-   472 021
DE-A- 3 039 483
DE-C- 2 416 212
DE-C- 2 952 106**

(73) Patentinhaber : **Dr. Johannes Heidenhain GmbH
Nansenstrasse 17
D-8225 Traunreut (DE)**

(72) Erfinder : **Schmitt, Walter, Ing. grad.
Hochgernstrasse 22
D-8225 Traunreut (DE)**

EP 0 121 658 B1

Jouve, 18, rue St-Denis, 75001 Paris, France

**Beschreibung**

Die Erfindung betrifft eine Meßeinrichtung gemäß dem Oberbegriff des Anspruchs 1.

Bei einer derartigen Meßeinrichtung können die an den Referenzmarken erzeugten elektrischen Steuerimpulse auf verschiedene Weise verwertet werden, z. B. zum Reproduzieren der Nullposition im Zähler, zum Anfahren einer bestimmten Position zu Beginn der Messung und zur Kontrolle von Störimpulsen sowie zur Beaufschlagung einer nachgeschalteten Steuereinrichtung.

Aus der DE-C-24 16 212 ist eine inkrementale Längen- oder Winkelmeßeinrichtung bekannt, bei der neben der inkrementalen Teilung Referenzmarken auf einer gesonderten Spur vorgesehen sind. Die Absolutwerte dieser Referenzmarken bestimmen sich aus den unterschiedlichen Abständen zwischen den einzelnen Referenzmarken ; diese Abstände zwischen den Referenzmarken werden durch Abtastung der inkrementalen Teilung ermittelt. Zur Erkennung der absoluten Position einer Referenzmarke müssen daher immer zwei Referenzmarken abgetastet werden. Dieses Verfahren ist umständlich und zeitraubend, wenn beispielsweise zwei derartige Referenzmarken weit auseinander liegen. Zudem können bei einer fehlerhaften Zählung der Inkremente zwischen zwei Referenzmarken falsche Abstände und damit falsche Absolutwerte für die Referenzmarken ermittelt werden.

In der DE-C-29 52 106 ist eine inkrementale Längen- oder Winkelmeßeinrichtung beschrieben, bei der auf einem Maßstab neben der Teilung Referenzmarken mit unterschiedlichen Strichgruppenverteilungen vorgesehen sind. Die einzelnen Referenzmarken werden von Abtastfeldern in einer Abtasteinheit abgetastet, wobei jedes Abtastfeld einer Referenzmarke eindeutig zugeordnet ist, indem es die gleiche Strichgruppenverteilung aufweist. Diese Anordnung ist relativ aufwendig, da die Strichgruppenverteilungen der einzelnen Referenzmarken sich möglichst stark voneinander unterscheiden müssen, um eine eindeutige Identifizierung der einzelnen Referenzmarken zu ermöglichen. Die Abtasteinheit muß dabei für jede Referenzmarke ein identisches Abtastfeld aufweisen.

Der DE-A-30 39 483 entnimmt man eine inkrementale Längen- oder Winkelmeßeinrichtung, bei der neben einer Teilungsspur parallel zueinander eine Referenzmarkenspur und eine Codemarkenspur angeordnet sind. Zur Abtastung der Referenzmarken und der jeweils zugehörigen Codemarkenteile sind aber gesonderte Abtastfelder in einer Abtasteinheit erforderlich, wobei jedem Codemarkenteil ein eigenes Abtastfeld zugeordnet ist.

Der Erfindung liegt die Aufgabe zugrunde, bei einer derartigen Meßeinrichtung die Abtastung der Referenzmarken und der zugehörigen Codemarkenteile wesentlich zu vereinfachen.

Diese Aufgabe wird erfindungsgemäß durch die Merkmale des Patentanspruchs 1 gelöst.

Die mit der Erfindung erzielten Vorteile bestehen insbesondere darin, daß die Anzahl der Abtastfelder durch die vorgeschlagene Anordnung der Codemarkenteile erheblich reduziert werden kann, da das Abtastfeld für die Codemarkenteile im Abtastfeld für die Referenzmarken integriert ist ; diesem gemeinsamen Abtastfeld ist lediglich ein Abtastelement zugeordnet. Diese Anordnung der Codemarkenteile ergibt bei der Abtastung der Referenzmarken lediglich einen Gleichspannungsanteil im erzeugten Abtastsignal, so daß eine sichere Erkennung der Referenzmarken und eine eindeutige Auslesung der Codeinformation der Codemarken gewährleistet ist.

Vorteilhafte Weiterbildungen der Erfindung entnimmt man den abhängigen Patentansprüchen.

Ausführungsbeispiele der Erfindung werden anhand der Zeichnung näher erläutert.

Es zeigen

Figur 1 schematisch eine inkrementale Längenmeßeinrichtung,

Figur 2 einen Maßstab und eine Abtastplatte der Längenmeßeinrichtung,

Figur 3 ein Signaldiagramm von Referenz- und Codesignalen und

Figur 4 einen Ausschnitt des Maßstabs und der Abtastplatte nach Figur 2.

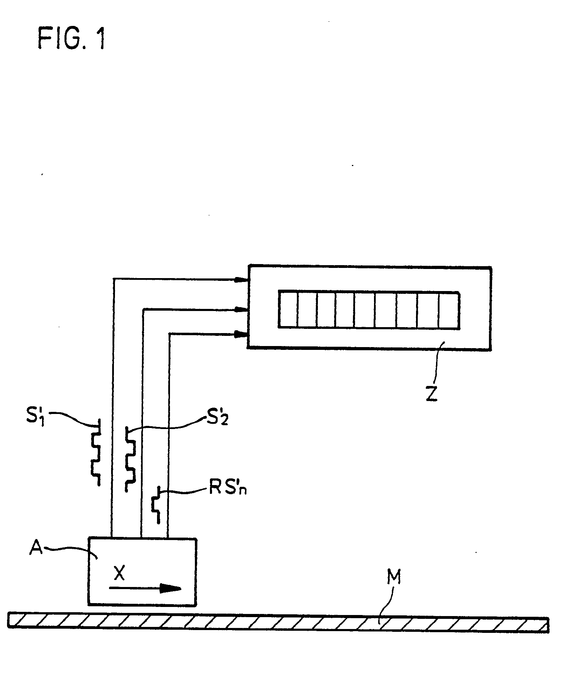

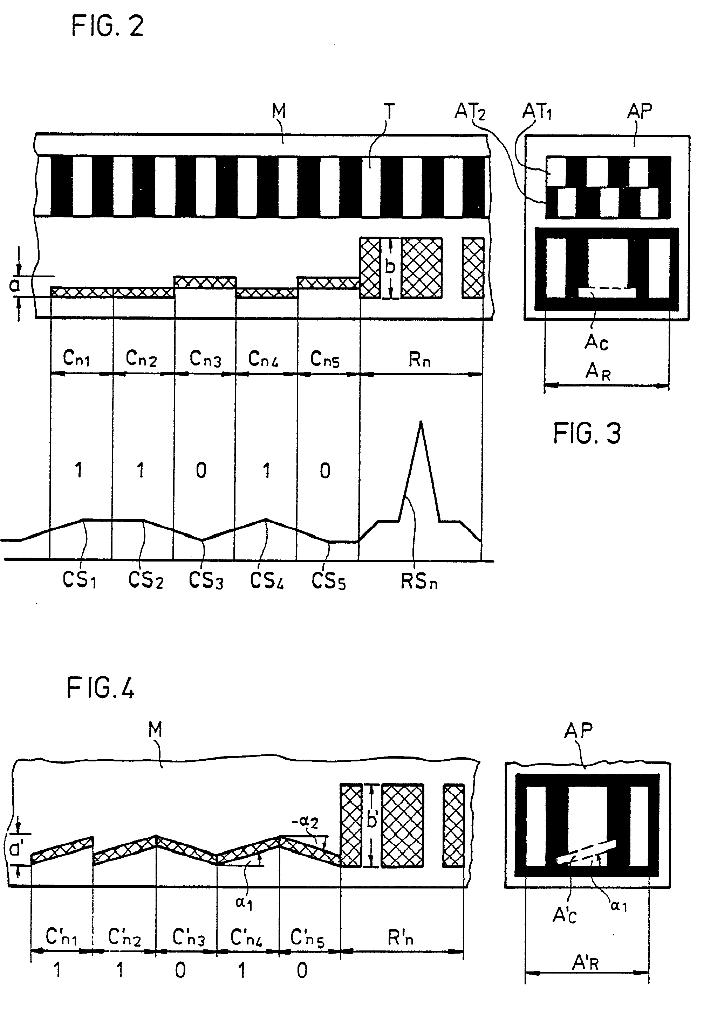

In Figur 1 ist schematisch eine lichtelektrische inkrementale Längenmeßeinrichtung gezeigt, die aus einem Maßstab M und aus einer Abtasteinheit A besteht, die jeweils in nicht dargestellter Weise mit zu messenden Objekten einer Bearbeitungsmaschine verbunden sind. Auf dem Maßstab M ist eine inkrementale Teilung T in Form eines Strichgitters (Figur 2) aufgebracht, die im Auflicht photoelektrisch berührungsfrei von der Abtasteinheit A abgetastet wird. Entlang der Teilung T ist auf dem Maßstab M eine Reihe von Referenzmarken $R_n$ (n = 1, 2, 3, ...) vorgesehen, die jeweils identische Strichgruppen mit einer bestimmten Strichverteilung aufweisen. Die durch die Abtastung der Teilung T erzeugten periodischen Abtastsignale $S_1$, $S_2$, die in der Abtasteinheit A verstärkt und in Rechtecksignale $S_1'$, $S_2'$, umgeformt werden, steuern einen elektronischen Zähler Z, der die Meßwerte in digitaler Form anzeigt. Die um ein Viertel der Gitterkonstanten (Teilungsperiode) der Teilung T zueinander phasenverschobenen Rechtecksignale $S_1'$, $S_2'$, dienen der Diskriminierung der Abtastrichtung. Das an den Referenzmarken $R_n$ erzeugte Referenzsignal $RS_n$ wird in der Abtasteinheit A verstärkt, in ein Rechtecksignal $RS_n'$ umgeformt und ebenfalls dem Zähler Z zugeleitet.

Mit den gewonnenen Referenzsignalen $RS_n$ können verschiedene Funktionen ausgelöst werden. Durch Auswertung der Referenzsignale $RS_n$ wird aus einer inkrementalen Meßeinrichtung eine quasi absolute Meßeinrichtung, wenn jeder Referenzmarke $R_n$ eine Zahl zugeordnet wird, die deren absolute Position, bezogen auf einen unveränderlichen Nullpunkt, darstellt. Ferner kann eine

bestimmte Referenzmarke $R_n$ dazu dienen, den Zähler Z beim Auftreten des aus der bestimmten Referenzmarke $R_n$ gewonnenen Referenzsignale $RS_n$ auf den Wert « Null » zu setzen. Diese Funktionen sind aber nur ausführbar, wenn die ausgewählte Referenzmarke $R_n$ eindeutig identifiziert werden kann.

Zur Identifizierung ist jeder der identischen Referenzmarken $R_n$ eine Codemarke $C_n$ seriell zugeordnet, die aus wenigstens einem Codemarkenteil $C_{nm}$ (n, m = 1, 2, 3, ...) besteht. Die Codemarkenteile $C_{nm}$ folgen in Meßrichtung X mit jeweils einem einheitlich durchgehenden Flächenbereich lückenlos aufeinander und sind gemäß Figur 2 zwischen den einzelnen Referenzmarken $R_n$ auf dem Maßstab M in Form von in Meßrichtung X verlaufenden Strichen angeordnet, die quer zur Meßrichtung X je nach ihrer Codeinformation parallel zueinander versetzt sind. Aus der Reihe von Referenzmarken $R_n$ ist nur eine Referenzmarke $R_n$ dargestellt, der die Codemarkenteile $C_{n1}$-$C_{n5}$ zugeordnet sind. Die Referenzmarke $R_n$ besteht aus einer Strichgruppe mit drei quer zur Meßrichtung X verlaufenden Strichen mit einer bestimmten Strichverteilung, die für alle Referenzmarken $R_n$ identisch ist.

Zur Abtastung des Maßstabs M ist in der Abtasteinheit A eine Abtastplatte AP gemäß Figur 2 vorgesehen, die zur Abtastung der Teilung T zwei um ein Viertel der Gitterkonstanten der Teilung T zueinander versetzte Abtastfelder $AT_1$, $AT_2$ aufweist, die mit der Teilung T identisch sind ; den Abtastfeldern $AT_1$, $AT_2$ sind nicht gezeigte Photoelemente zur Erzeugung der Abtastsignale $S_1$, $S_2$ zugeordnet. Zur Abtastung der Referenzmarke $R_n$ ist auf der Abtastplatte AP ein Abtastfeld AR vorgesehen, dem ein nicht dargestelltes Photoelement zur Erzeugung des Referenzsignals $RS_n$ zugeordnet ist. Zur Abtastung der unteren Reihe von Codemarkenteilen $C_{n1}$, $C_{n2}$, $C_{n4}$ ist auf der Abtastplatte AP ein Abtastfeld AC vorgesehen, das im Abtastfeld AR integriert ist ; das genannte Photoelement dient gleichfalls der Erzeugung der Codesignale $CS_{n1}$-$CS_{n5}$. Der oberen Reihe von Codemarkenteilen $C_{n3}$, $C_{n5}$ ist kein Abtastfeld zugeordnet. Das Abtastfeld AR stimmt mit der Referenzmarke $R_n$ und das Abtastfeld AC mit den Codemarkenteilen $C_{nm}$ überein.

Die bei der Abtastung des Maßstabs M in positiver Meßrichtung X von links nach rechts vom Abtastfeld AC erzeugten Codesignale $CS_{n1}$-$CS_{n5}$ ergeben die Binärkombination « 11010 » zur eindeutigen Identifizierung der zugehörigen Referenzmarke $R_n$ (Figur 3). Die Codemarkenteile $C_{n1}$-$C_{n5}$ werden auch von dem Abtastfeld AR für die Referenzmarke $R_n$ abgetastet. Da die Codemarkenteile $C_{n1}$-$C_{n5}$ entsprechend ihrer Codeinformation parallel zueinander versetzt sind, ohne daß in Meßrichtung X eine Lücke entsteht, und da die Gesamtbreite a der parallel versetzten Codemarkenteile $C_{n1}$-$C_{n5}$ nur einen Teil der Breite b der Referenzmarke $R_n$ senkrecht zur Meßrichtung X beträgt, wird bei der Abtastung der Codemarkenteile $C_{n1}$-$C_{n5}$ vom Abtastfeld AR im zugeordneten Photoelement lediglich ein Gleichspannungssignal erzeugt, das die exakte Ermittlung des Referenzsignals $RS_n$ nicht beeinträchtigt. Die Codesignale $CS_{n1}$-$CS_{n5}$ werden der Auswerteeinrichtung im Zähler Z zugeleitet.

Wenn die Abtasteinheit A den Maßstab M in positiver Meßrichtung X von links nach rechts abtastet, so folgen auf die Referenzmarke $R_n$ die nächsten Codemarkenteile $C_{n+1,m}$ und darauf die zugehörige Referenzmarke $R_{n+1}$ etc. (in der Figur 2 nicht dargestellt). Um bei dieser Abtastrichtung den ersten Codemarkenteil $C_{n+1,1}$ erkennen zu können, sollte dieser Codemarkenteil $C_{n+1,1}$ beispielsweise den Binärwert « 1 » besitzen. Ganz allgemein können die Codemarkenteile $C_{nm}$ Anfangs- und Endinformationen aufweisen. Mit der Anfangsinformation kann die Auswerteeinrichtung im Zähler Z darauf vorbereitet werden, daß im Anschluß an die Anfangsinformation eine Codeinformation ausgelesen wird. Die Endinformation dient zur Sicherstellung, daß die gesamte Codeinformation ausgelesen wurde ; dadurch kann eine eventuelle Umkehrung der Meßrichtung X mitten in der Abtastung der Codeinformation erkannt werden.

Bei der Bewegung der Abtasteinheit A in positiver Meßrichtung X von links nach rechts erfolgt die Abtastung der Codeinformation der Codemarkenteile $C_{nm}$ vor der Abtastung der zugehörigen Referenzmarke $R_n$. Bei der Abtastbewegung in negativer Meßrichtung —X von rechts nach links wird durch die richtungsabhängige Auswertung der Codeinformationen erkannt, daß nach den Codemarkenteilen $C_{n+1,m}$ die Referenzmarke $R_n$ folgen muß.

Zweckmäßig werden die Codemarkenteile $C_{nm}$ und die Referenzmarken $R_n$ in Meßrichtung X als ganzzahliger Teil oder als ganzzahliges Vielfaches der Inkrementalteilung T auf dem Maßstab M ausgebildet, so daß die Abtastung der Codemarkenteile $C_{nm}$ und der Referenzmarken $R_n$ im Takt der Abtastung der Inkrementalteilung T erfolgt.

Nach Figur 4 sind auf einem Ausschnitt des Maßstabs M gemäß Figur 2 eine Referenzmarke $R_n'$ sowie zugehörige Codemarkenteile $C_{n1}'$-$C_{n5}'$ seriell angeordnet. Diese Codemarkenteile $C_{nm}'$ schließen je nach ihrer Codeinformation mit der positiven Meßrichtung X einen Winkel $0° < + \alpha_1 < 90°$ oder einen Winkel $0° < - \alpha_2 < - 90°$ ein ; dem Winkel $\alpha_1$ ist beispielsweise die Codeinformation « 1 » und dem Winkel $\alpha_2$ die Codeinformation « 0 » zugeordnet. Auf der Abtastplatte AP ist ein Abtastfeld AC' für die Codemarkenteile $C_{n1}'$-$C_{n5}'$ vorgesehen, daß mit der positiven Meßrichtung X den Winkel $\alpha_1$ gemäß der Codeinformation « 1 » einschließt. Die Abtastung der Codemarkenteile $C_{n1}'$-$C_{n5}'$ ergibt demgemäß die Binärkombination « 11010 » zur eindeutigen Identifizierung der zugehörigen Referenzmarke $R_n'$. Die Codemarkenteile $C_{n1}'$-$C_{n5}'$ werden auch vom Abtastfeld AR für die Referenzmarke $R_n'$ abgetastet. Da die Codemarkenteile $C_{n1}'$-$C_{n5}'$ entsprechend ihrer Codeinformation unter den Winkel $\alpha_1$, $\alpha_2$ lückenlos in Meßrichtung X angeordnet sind und da die Breite a' der

Codemarkenteile $C_{n1}'$-$C_{ns}'$ nur einen Teil der Breite b' der Referenzmarke $R_n'$ senkrecht zur Meßrichtung X beträgt, wird bei der Abtastung der Codemarkenteile $C_{n1}'$-$C_{ns}'$ vom Abtastfeld AR' im zugeordneten Photoelement lediglich ein Gleichspannungssignal erzeugt, das die exakte Ermittlung des Referenzsignals $RS_n'$ nicht beeinträchtigt. Die Codesignale $CS_{n1}'$-$CS_{ns}'$ werden der Auswerteeinrichtung im Zähler Z zugeleitet. Das Abtastfeld AR' stimmt mit der Referenzmarke $R_n'$ und das im Abtastfeld AR' integrierte Abtastfeld AC' mit den Codemarkenteilen $C_{nm}'$ entsprechend der Codeinformation « 1 » überein.

Die Auswertung der erzeugten Codesignale $CS_{nm}$, $CS_{nm}'$ erfolgt in der Auswerteeinrichtung des Zählers Z. Diese Auswerteeinrichtung kann eine Auswahleinrichtung enthalten, mit deren Hilfe bestimmte Referenzmarken $R_n$, $R_n'$ aus der Reihe der Referenzmarken $R_n$, $R_n'$ ausgewählt und zur Wirkung gebracht werden können.

**Patentansprüche**

1. Meßeinrichtung, insbesondere inkrementale Meßeinrichtung, mit entlang der Teilung einer Maßverkörperung in Meßrichtung vorgesehenen identischen Referenzmarken, die der Teilung absolut zugeordnet sind und denen zur Identifizierung jeweils eine aus wenigstens zwei Codemarkenteilen bestehende Codemarke zugeordnet ist, sowie mit einer Abtasteinheit zur Abtastung der Teilung, der Referenzmarken und der jeweils zugehörigen Codemarken, der ein Zähler der Meßeinrichtung und/oder eine Steuereinrichtung nachgeschaltet ist, dadurch gekennzeichnet, daß jeder der identischen Referenzmarken ($R_n$) seriell eine aus wenigstens einem Codemarkenteil ($C_{nm}$) (n, m = 1, 2, 3 ...) bestehende Codemarke ($C_n$) zugeordnet ist, daß jeder Codemarkenteil ($C_{nm}$) in Meßrichtung X einen einheitlich durchgehenden Flächenbereich aufweist, daß die Codemarkenteile ($C_{nm}$) jeder Codemarke ($C_n$) in Meßrichtung X lückenlos aufeinander folgen und daß ferner Codemarkenteile ($C_{nm}$) entsprechend ihrer Codeinformation quer zur Meßrichtung X zueinander versetzt sind.

2. Meßeinrichtung nach Anspruch 1, dadurch gekennzeichnet, daß zur seriellen Abtastung der Referenzmarken ($R_n$) und der Codemarkenteile ($C_{nm}$) das Abtastfeld (AC) für die Codemarkenteile ($C_{nm}$) im Abtastfeld (AR) für die Referenzmarken ($R_n$) integriert ist und daß den Abtastfeldern (AC, AR) ein gemeinsames Photoelement zugeordnet ist.

3. Meßeinrichtung nach Anspruch 1, dadurch gekennzeichnet, daß die Codemarkenteile ($C_{nm}$) entsprechend ihrer Codeinformation quer zur Meßrichtung X parallel zueinander versetzt angeordnet sind.

4. Meßeinrichtung nach Anspruch 1, dadurch gekennzeichnet, daß die Codemarkenteile ($C_{nm}'$) entsprechend ihrer Codeinformation unter Winkeln $+\alpha_1$, $-\alpha_2$ zur Meßrichtung X angeordnet sind.

5. Meßeinrichtung nach Anspruch 1, dadurch gekennzeichnet, daß die Codemarkenteile ($C_{nm}$) außer den Identifizierungsmerkmalen für die zugehörigen Referenzmarken ($R_n$) noch wenigstens Informationen zur Vollständigkeitserkennung aufweisen.

6. Meßeinrichtung nach Anspruch 1, dadurch gekennzeichnet, daß die Codemarkenteile ($C_{nm}$) und die Referenzmarken ($R_n$) als ganzzahliger Teil oder als ganzzahliges Vielfaches der Teilungsperiode der Teilung (T) des Maßstabs (M) ausgebildet sind.

7. Meßeinrichtung nach Anspruch 4, dadurch gekennzeichnet, daß die Winkel $+\alpha_1$, $-\alpha_2$ in Bereichen $0° < +\alpha_1 < 90°$ und $0° < -\alpha_2 < -90°$ liegen.

**Claims**

1. Measuring device, in particular incremental measuring device, with identical reference marks provided in measuring direction along the graduation of an embodiment of a measure, which reference marks are assigned absolutely to the graduation and to each of which reference marks is assigned, for identification, a code mark consisting of at least two code mark parts, as well as with a scanning unit for scanning of the graduation, the reference marks and the respective associated code marks, downstream of which scanning unit is connected a counter of the measuring device and/or a control device, characterized in that each of the identical reference marks ($R_n$) is assigned serially a code mark ($C_n$) consisting of at least one code mark part ($C_{nm}$) (n, m = 1, 2, 3 ...), in that each code mark part ($C_{nm}$) has in measuring direction X a uniformly continuous surface area, in that the code mark parts ($C_{nm}$) of each code mark ($C_n$) follow successively without gap in measuring direction X and in that, furthermore, code mark parts ($C_{nm}$) are offset relative to one another transverse to measuring direction X according to their code information.

2. Measuring device according to Claim 1, characterized in that, for the serial scanning of the reference marks ($R_n$) and the code mark parts ($C_{nm}$), the scanning field (AC) for the code mark parts ($C_{nm}$) is integrated in the scanning field (AR) for the reference marks ($R_n$) and in that the scanning fields (AC, AR) are assigned a common photoelement.

3. Measuring device according to Claim 1, characterized in that the code mark parts ($C_{nm}$) are offset parallel to one another transverse to measuring direction X according to their code information.

4. Measuring device according to Claim 1, characterized in that the code mark parts ($C_{nm}'$) are arranged at angles $+\alpha_1$, $-\alpha_2$ to measuring direction X according to their code information.

5. Measuring device according to Claim 1, characterized in that the code mark parts ($C_{nm}$) have, apart from the identification features for the

associated reference marks ($R_n$), also at least information for completeness recognition.

6. Measuring device according to Claim 1, characterized in that the code mark parts ($C_{nm}$) and the reference marks ($R_n$) are designed as an integral part or as an integral multiple of the graduation period of the graduation (T) of the scale (M).

7. Measuring device according to Claim 4, characterized in that the angles $+ \alpha_1$, $- \alpha_2$ lie in ranges $0° < + \alpha_1 < 90°$ and $0° < - \alpha_2 < - 90°$.

**Revendications**

1. Dispositif de mesure, notamment incrémentiel, avec des marques de référence identiques prévues en direction de mesure le long de la graduation d'un système d'échelle, lesquelles sont affectées absolument à ladite graduation, une marque de code composée d'au moins deux éléments de marque de code leur étant chaque fois affectée aux fins d'identification, ainsi qu'avec une unité exploratrice pour exploration de la graduation, des marques de référence et des marques de code chaque fois afférentes, laquelle est suivie d'un compteur du dispositif de mesure et/ou d'un dispositif de commande, dispositif de mesure caractérisé par le fait qu'à chacune des marques de référence identiques ($R_n$) est affectée en ordre sériel une marque de code ($C_n$) composée d'au moins un élément de marque de code ($C_{nm}$) (n, m = 1, 2, 3 ...), que chaque élément de marque de code ($C_{nm}$) comporte en direction de mesure X une zone de surface continue uniforme, que les éléments de marque de code ($C_{nm}$) de chaque marque de code ($C_n$) se suivent sans interruption en direction de mesure X et que, en outre, des éléments de marque de code ($C_{nm}$) sont décalés les uns par rapport aux autres transversalement à la direction de mesure X conformément à leur information de code.

2. Dispositif de mesure selon la revendication 1 caractérisé par le fait que, pour l'exploration sérielle des marques de référence ($R_n$) et des éléments de marque de code ($C_{nm}$), le champ d'exploration (AC) des éléments de marque de code ($C_{nm}$) est intégré dans le champ d'exploration (AR) des marques de référence ($R_n$) et qu'un photo-élément commun est affecté auxdits champs d'exploration (AC, AR).

3. Dispositif de mesure selon la revendication 1 caractérisé par le fait que les éléments de marque de code ($C_{nm}$) sont décalés parallèlement les uns par rapport aux autres en direction transversale à la direction de mesure X conformément à leur information de code.

4. Dispositif de mesure selon la revendication 1 caractérisé par le fait que les éléments de marque de code ($C_{nm}'$) sont disposés sous des angles $+ \alpha_1$, $- \alpha_2$ avec la direction de mesure X conformément à leur information de code.

5. Dispositif de mesure selon la revendication 1 caractérisé par le fait qu'en dehors des caractéristiques d'identification des marques de référence ($R_n$) afférentes, les éléments de marque de code ($C_{nm}$) comportent au moins des informations pour la reconnaissance du caractère complet.

6. Dispositif de mesure selon la revendication 1 caractérisé par le fait que les éléments de marque de code ($C_{nm}$) et les marques de référence ($R_n$) sont établis en part entière ou en multiple entier de la période de graduation de la graduation (T) de l'échelle (M).

7. Dispositif de mesure selon la revendication 4 caractérisé par le fait que les angles $+ \alpha_1$, $- \alpha_2$ sont compris dans les intervalles $0° < + \alpha_1 < 90°$ et $0° < - \alpha_2 < - 90°$.

FIG. 1

FIG. 2

FIG. 3

FIG. 4